# EUROPÄISCHE PATENTSCHRIFT

(11) **EP 1 853 951 B1**
(45) Veröffentlichungstag und Bekanntmachung des Hinweises auf die Patenterteilung: **05.09.2018**
(21) Anmeldenummer: 06705886.7
(22) Anmeldetag: 02.02.2006
(51) Int. Cl.: F21V 8/00, G02B 6/00, H01L 33/58, H01L 33/60

(54) **Optoelektronisches Bauteil mit einem Lichtleiter**
Optoelectronic component with a light guide
Composant optoélectronique avec guide de lumière

(30) Priorität: 28.02.2005 DE 102005009028; 20.04.2005 DE 102005018336
(43) Veröffentlichungstag der Anmeldung: 14.11.2007
(73) Patentinhaber: OSRAM Opto Semiconductors GmbH, 93055 Regensburg (DE)
(72) Erfinder: GRÖTSCH, Stefan, 93077 Lengfeld/bad Abbach (DE)
(74) Vertreter: Epping - Hermann - Fischer
(86) Internationale Anmeldenummer: PCT/DE2006/000157
(87) Internationale Veröffentlichungsnummer: WO 2006/089503

(56) Entgegenhaltungen:
- EP-A- 1 213 773
- EP-A- 1 306 697
- EP-A- 1 434 277
- EP-A1- 0 534 853
- DE-A1- 19 907 553
- US-A- 4 765 718
- US-A- 4 950 059
- US-B1- 6 819 505

## Beschreibung

Es wird ein optoelektronisches Bauteil mit einem Lichtleiter angegeben.

Die Druckschriften DE 199 07 553 A1, US 4,765,718 und EP 1 434 277 A1 beschreiben jeweils einen Lichtleiter.

Die Druckschriften US 6,819,505 B1, EP 0 534 853 A1 und WO 02/50472 A1 beschreiben jeweils einen Lichtleiter sowie ein optoelektronisches Bauteil mit einem Lichtleiter.

Eine zu lösende Aufgabe besteht darin, ein optoelektronisches Bauteil mit einem Lichtleiter anzugeben, der elektromagnetische Strahlung besonders verlustfrei führen kann.

Die Erfindung betrifft ein optoelektronisches Bauteil gemäß Anspruch 1.

Es wird ein Lichtleiter angegeben. Unter einem Lichtleiter ist ein optisches Bauelement zu verstehen, das geeignet ist, elektromagnetische Strahlung von einem Ort zu einem anderen Ort zu führen. Die Führung der elektromagnetischen Strahlung erfolgt dabei vorzugsweise durch Reflexionen an den Lichtleiter begrenzenden Seitenflächen.

Gemäß der Erfindung weist der Lichtleiter eine unebene Lichteintrittsfläche auf. Unter Lichteintrittsfläche ist dabei der Teil der Oberfläche des Lichtleiters zu verstehen, der für die Einkopplung elektromagnetischer Strahlung in den Lichtleiter vorgesehen ist. Gemäß der Erfindung ist in Nähe der Lichteintrittsfläche eine Strahlungsquelle angeordnet, die zur Erzeugung elektromagnetischer Strahlung geeignet ist. Zumindest ein Teil der von der Strahlungsquelle emittierten elektromagnetischen Strahlung tritt durch die Lichteintrittsfläche in den Lichtleiter ein und wird vom Lichtleiter von dieser weggeführt. Die Unebenheit der Lichteintrittsfläche bezieht sich dabei auf makroskopische Unebenheiten. Das heißt, dass die Lichteintrittsfläche nicht als plane Fläche ausgebildet ist, sondern beispielsweise zumindest eine makroskopische Ausnehmung und/oder eine makroskopische Erhebung aufweist.
Bevorzugt ist die Unebenheit der Lichteintrittsfläche dabei so gewählt, dass die Lichteinkopplung in den Lichtleiter aufgrund der Unebenheit verbessert ist. Das kann zum Beispiel heißen, dass ein größerer Anteil der von einer Strahlungsquelle erzeugten elektromagnetischen Strahlung in den Lichtleiter eintreten kann, als dies bei einer ebenen Lichteintrittsfläche der Fall wäre. Es kann weiter auch bedeuten, dass die Richtung der in den Lichtleiter eintretenden elektromagnetischen Strahlen aufgrund der Unebenheit der Lichteintrittsfläche zumindest teilweise geändert wird. Dadurch kann beispielsweise erreicht sein, dass die eingekoppelte Strahlung länger im Lichtleiter verbleibt und nicht in der unmittelbaren Nähe der Lichteintrittsfläche wieder aus diesem austritt. Bevorzugt weist der Lichtleiter dabei eine einzige Lichteintrittsfläche auf. Gemäß der Erfindung weist der Lichtleiter Seitenflächen auf. Unter Seitenflächen sind dabei Teile der Oberfläche des Lichtleiters zu verstehen, die den Lichtleiter seitlich begrenzen. Bevorzugt wird ein Großteil der elektromagnetischen Strahlung, die in den Lichtleiter eingekoppelt ist und auf eine Seitenfläche trifft, von dieser reflektiert. Die Reflexion kann beispielsweise mittels Totalreflexion an der Seitenfläche erfolgen. Falls die auf die Seitenflächen fallende Strahlung die Bedingung für Totalreflexion nicht erfüllt, tritt die aus dem Lichtleiter austretende elektromagnetische Strahlung an den Seitenflächen vom optisch dichteren Medium - mit dem größeren Brechungsindex - in das optisch dünnere Medium mit dem kleineren Brechungsindex. Es ist aber auch möglich, dass die Seitenflächen etwa mittels einer reflektierenden Beschichtung reflektierend ausgebildet sind. Gemäß der Erfindung sind die Seitenflächen eben. Das heißt, die Seitenflächen weisen keine makroskopischen Ausnehmungen, Erhebungen oder Krümmungen auf, sondern sind als plane Flächen ausgebildet. Das heißt, die Seitenflächen sind makroskopisch glatt ausgebildet.

Die ebenen Seitenflächen sind der Lichteintrittsfläche direkt nachgeordnet. Die ebenen Seitenflächen schließen sich also direkt an den Teil der Oberfläche des Lichtleiters an, der die Lichteintrittsfläche enthält. Die Seitenflächen können die Lichteintrittsfläche dabei seitlich umschließen. Es ist auch möglich, dass die Seitenflächen direkt an die Lichteintrittsfläche grenzen. Gemäß der Erfindung weist der Lichtleiter eine unebene Lichteintrittsfläche und ebene Seitenflächen auf, die der Lichteintrittsfläche direkt nachgeordnet sind. Der Lichtleiter macht sich dabei die Idee zunutze, dass in den Lichtleiter eintretende Strahlung aufgrund der Unebenheit der Lichteintrittsfläche in definierter Weise gebrochen wird. Ein Teil der durch die Lichteintrittsfläche in den Lichtleiter eingekoppelten Strahlung trifft dann auf eine der ebenen Seitenflächen, die der Lichteintrittsfläche direkt nachgeordnet ist und wird von dieser zumindest zum überwiegenden Teil in den Lichtleiter reflektiert. Auf diese Weise kann ein besonders großer Anteil der von einer Strahlungsquelle emittierten Strahlung in den Lichtleiter eingekoppelt und in diesem gehalten werden, bis sie eine zum Lichtaustritt vorgesehen Lichtaustrittsfläche des Lichtleiters erreicht. Gemäß der Erfindung nimmt die Querschnittsfläche des Lichtleiters mit dem Abstand von der Lichteintrittsfläche zu. Die Querschnittsfläche bei einem gegebenen Abstand zur Lichteintrittsfläche ist durch die Schnittlinie der Seitenflächen des Lichtleiters mit einer Ebene, die sich in diesem Abstand zur Lichteintrittsfläche befindet, gegeben. Die Querschnittsfläche ist dabei die kleinst mögliche Fläche, die in einem bestimmten Abstand von der Leichteintrittsfläche die den Lichtleiter begrenzenden Seitenflächen schneidet.
Ein Aufweiten der Querschnittsfläche des Lichtleiters mit dem Abstand von der Lichteintrittsfläche ist dadurch erreicht, dass der Lichtleiter eine kegelstumpf- oder pyramidenstumpfartige Form aufweist. Die Lichteintrittsfläche ist an der der Basis des Stumpfes abgewandten Seite des Lichtleiters angeordnet. Gemäß der Erfindung nimmt die Querschnittsfläche des Lichtleiters in einem ersten Abschnitt des Lichtleiters stärker zu, als in einem zweiten Abschnitt des Lichtleiters. "Stärker zunehmen" bedeutet zum Beispiel, dass beim Vergleich zweier Teilstücke des Lichtleiters gleicher Länge der Flächeninhalt der Querschnittsfläche in Strahlrichtung bei einem Teilstück das im ersten Abschnitt liegt sich prozentual mehr vergrößert als bei einem Teilstück, das im zweiten Abschnitt liegt. Es kann auch bedeuten, dass bis zu einem bestimmten ersten Abstand von der Lichteintrittsfläche die Querschnittsfläche stärker zunimmt als von diesem ersten Abstand zu einem zweiten Abstand von der Lichteintrittsfläche. Der Lichtleiter gliedert sich dann in wenigstens zwei Abschnitte: einen ersten Abschnitt, von der Lichteintrittsfläche bis zu einem vorgegebenen Abstand von der Lichteintrittsfläche, in dem die Querschnittsfläche stärker zunimmt als in einem zweiten Abschnitt, der dem ersten Abschnitt nachgeordnet ist. Gemäß der Erfindung ist der erste Abschnitt der Lichteintrittsfläche des Lichtleiters direkt nachgeordnet. Das heißt, zumindest in diesem ersten Abschnitt können die Seitenflächen des Lichtleiters eben ausgebildet sein. Gemäß der Erfindung ist die Zunahme der Querschnittsfläche mit dem Abstand von der Lichteintrittsfläche im ersten Abschnitt des Lichtleiters dadurch realisiert, dass die Seitenflächen des Lichtleiters jeweils erste Winkel mit der Querschnittsfläche des Lichtleiters einschließen. Die ersten Winkel sind dabei größer 90 Grad. Beispielsweise können die ersten Winkel für jede Seitenfläche gleich groß gewählt sein. Gemäß der Erfindung schließen die Seitenflächen im zweiten Abschnitt des Lichtleiters zweite Winkel mit der Querschnittsfläche des Lichtleiters ein. Die ersten Winkel sind größer als die zweiten Winkel. Dadurch kann erreicht sein, dass die Querschnittsfläche des Lichtleiters im ersten Abschnitt stärker als im zweiten Abschnitt zunimmt. So ist der Lichtleiter derart aufgebaut, dass ein erster Pyramidenstumpf den ersten Abschnitt des Lichtleiters bildet. Dem ersten Pyramidenstumpf schließt sich ein zweiter Pyramidenstumpf an. Der Lichtleiter ist dann insgesamt in der Form zweier aneinander gereihter Pyramidenstümpfe ausgeführt. Dabei schließen die Seitenflächen des ersten Pyramidenstumpfs einen größeren Winkel mit der Querschnittsfläche ein als die Seitenflächen des zweiten Pyramidenstumpfs.
Darüber hinaus sind aber auch andere Formen für die ersten und zweiten Abschnitte des Lichtleiters möglich. So kann der Lichtleiter auch in der Form zweier hintereinander angeordneter Kegelstümpfe gegeben sein.
Weiter kann der Lichtleiter mehr als zwei Abschnitte aufweisen. Beispielsweise kann sich dem zweiten Abschnitt an seiner der Lichteintrittsfläche abgewandten Seite ein dritter Abschnitt anschließen. Im dritten Abschnitt können die Seitenflächen dritte Winkel mit der Querschnittsfläche einschließen, die beispielsweise kleiner als die zweiten Winkel sind.
Der Lichtleiter macht sich unter anderem die Idee zunutze, zumindest zwei optische Konzentratoren hintereinander anzuordnen. Dabei werden die Konzentratoren so durchstrahlt, dass die Lichteintrittsöffnung die eigentliche Lichtaustrittsöffnung der Konzentratoren ist. Das heißt, die optischen Konzentratoren werden jeweils in umgekehrter Richtung durchstrahlt. Dadurch kann eine Verringerung der Divergenz des durch den Konzentrator tretenden Strahlenbündels erreicht werden. Weiter sind die Konzentratoren jeweils geeignet, die durch sie tretende elektromagnetische Strahlung zu durchmischen. Ist der Leichtleiter beispielsweise mehreren Lichtquellen nachgeordnet, die geeignet sind, Licht voneinander unterschiedlicher Farbe zu erzeugen, so kann der optische Konzentrator zur Farbdurchmischung dienen. Beispielsweise kann dann das Licht von grünen, blauen und roten Leuchtdiodenchips oder Leuchtdioden zu besonders homogenem weißen Licht gemischt werden.
Bevorzugt ist der erste Konzentrator - im ersten Abschnitt des Lichtleiters - derart ausgebildet, dass er besonders divergente Strahlung aufnehmen kann und deren Divergenz soweit verringert, dass wiederum der zweite Konzentrator diese Strahlung geringerer Divergenz aufnehmen kann. Der zweite Konzentrator ist dann bevorzugt geeignet die Divergenz des Strahlenbündels weiter zu reduzieren. An den zweiten Konzentrator können sich in gleicher Weise weitere Konzentratoren anschließen. Gemäß der Erfindung sind die Seitenflächen des zweiten Abschnitts dabei eben ausgebildet. Das heißt ähnlich zu den Seitenflächen des ersten Abschnitts weisen die Seitenflächen des zweiten Abschnitts keine makroskopischen Ausnehmungen, Erhebungen oder Krümmungen auf, sondern sind makroskopisch glatt ausgebildet.

Gemäß zumindest einer Ausführungsform des Lichtleiters betragen die ersten Winkel zwischen 100 und 180 Grad, bevorzugt zwischen 125 und 140 Grad.
Gemäß zumindest einer Ausführungsform des Lichtleiters betragen die zweiten Winkel zwischen 90 und 140 Grad, bevorzugt zwischen 95 und 135 Grad. Gemäß der Erfindung beträgt die Länge des ersten Abschnitts des Lichtleiters maximal 20 Prozent der Gesamtlänge des Lichtleiters. Bevorzugt beträgt die Länge des ersten Abschnitts maximal 10 Prozent der Gesamtlänge. Die Länge des ersten Abschnitts ist dabei von der Seite des Lichtleiters gemessen, der die Lichteintrittsfläche aufweist. Die Länge des Lichtleiters ergibt sich dann als der Abstand der Lichteintrittsfläche zu einer Lichtaustrittsfläche des Lichtleiters.

Gemäß zumindest einer Ausführungsform des Lichtleiters ist die Lichteintrittsfläche konkav ausgebildet. Das heißt die Lichteintrittsfläche begrenzt eine Ausnehmung, die sich in den Lichtleiter erstreckt. Dabei kann die Ausnehmung die gesamte Fläche des Lichtleiters, in der sie sich befindet, umfassen. Es ist aber auch möglich, dass die Ausnehmung nur einen Teil dieser Fläche umfasst. Andere Teile dieser Fläche sind dann zum Beispiel eben ausgebildet.

Bevorzugt weist die Lichteintrittsfläche eine konkave Krümmung auf. Das heißt die Lichteintrittsfläche begrenzt einen konkav in den Lichtleiter gekrümmten Bereich.

Gemäß zumindest einer Ausführungsform ist die Lichteintrittsfläche sphärisch gekrümmt. Das heißt, die Lichteintrittsfläche ist zumindest stellenweise durch einen Teil einer Kugeloberfläche gegeben.

Gemäß zumindest einer Ausführungsform weist.die Lichteintrittsfläche eine elliptische Krümmung auf. Die Lichteintrittsfläche ist dann zumindest stellenweise durch einen Teil der Oberfläche eines Ellipsoids gegeben.

Gemäß zumindest einer Ausführungsform weist die Lichteintrittsfläche eine asphärische Krümmung auf. Das heißt die Lichteintrittsfläche ist zumindest stellenweise durch einen Teil der Oberfläche einer Rotationsasphäre gegeben. Eine zumindest teilweise asphärisch gekrümmte Lichteintrittsfläche erlaubt dabei durch Wahl von Formparametern der Rotationsasphäre die in den Lichtleiter eintretende Strahlung beim Durchtritt durch die Lichteintrittsfläche besonders definiert zu brechen.

Gemäß zumindest einer Ausführungsform ist die Lichteintrittsfläche bikonisch geformt. Die Lichteintrittsfläche kann dabei sowohl sphärisch und/oder asphärisch gekrümmt sein.

Durch eine gekrümmte Lichteintrittsfläche kann zum einen der Anteil der von einer Strahlungsquelle emittierten elektromagnetischen Strahlung, der eingekoppelt wird, maximiert werden. Zum anderen kann die Strahlung derart gebrochen werden, dass sie möglicht lang im Lichtleiter verbleiben kann. Zum Beispiel wird die eintretende Strahlung in Winkeln zu einer Seitenfläche des Lichtleiters hingebrochen, die die Bedingung für Totalreflexion an der Seitenfläche erfüllen. Auf diese Weise kann der Anteil der eingekoppelten Strahlung, der den Lichtleiter nicht durch die Seitenfläche, sondern durch eine zum Lichtaustritt vorgesehene Lichtaustrittsfläche verlässt optimiert werden. Weiter kann mit Hilfe einer gekrümmten Lichteintrittsfläche die Divergenz des Strahlenbündels schon bei Eintritt in den Lichtleiter verringert werden.

Gemäß zumindest einer Ausführungsform des Lichtleiters weist der Lichtleiter eine Lichtaustrittsfläche auf. Durch die Lichtaustritts.fläche tritt ein Großteil der durch die Lichteintrittsfläche in den Lichtleiter eingekoppelten Strahlung aus dem Lichtleiter aus. Bevorzugt ist die Lichtaustrittsfläche an der der Lichteintrittsfläche gegenüberliegenden Seite des Lichtleiters angeordnet. Ein Großteil der Strahlung bedeutet, dass beispielsweise besonders divergente Strahlung durch eine der Seitenflächen austreten kann, bevor sie die Lichtaustrittsfläche erreicht. Ein überwiegender Teil der in den Lichtleiter eingekoppelten Strahlung verlässt diesen jedoch durch die Lichtaustrittsfläche.

Gemäß zumindest einer Ausführungsform des Lichtleiters ist die Lichtaustrittsfläche eben ausgebildet. Das heißt, sie weist keine makroskopische Ausnehmung, Erhebung oder Krümmung auf.

Gemäß zumindest einer Ausführungsform weist die Lichtaustrittsfläche eine Krümmung auf. Das heißt zumindest ein Teil der Fläche des Lichtleiters, der zur Auskopplung elektromagnetischer Strahlung aus dem Lichtleiter vorgesehen ist, ist gekrümmt. Die Krümmung kann dabei konkav, das heißt, in den Lichtleiter hinein oder konvex, also aus dem Lichtleiter heraus, ausgebildet sein.
Gemäß zumindest einer Ausführungsform weist die Lichtaustrittsfläche eine der folgenden Krümmungen auf: Sphärisch, elliptisch, asphärisch, bikonisch, bikonisch sphärisch, bikonisch asphärisch. Weiter ist es möglich, dass die Lichtaustrittsfläche durch eine Freiformfläche gegeben ist, die zum Beispiel Krümmungen höherer Ordnung aufweisen kann.
Durch die Krümmung der Lichtaustrittsfläche kann die Divergenz aus dem Lichtleiter austretender Strahlung weiter verringert werden. Außerdem ist es möglich, mit Hilfe der Krümmung der Lichtaustrittsfläche eine besonders gleichmäßige Verteilung der Strahlung beim Austritt aus dem Lichtleiter zu erreichen. Damit kann eine Fläche, die mit aus dem Lichtleiter austretender elektromagnetischer Strahlung beleuchtet wird, besonders gleichmäßig ausgeleuchtet werden. Gemäß der Erfindung ist der Lichtleiter als Vollkörper ausgebildet. Das kann beispielsweise heißen, dass der Lichtleiter einteilig aus einem einheitlichen Material gebildet ist. Bevorzugt enthält der Lichtleiter ein dielektrisches Material, das für die in den Lichtleiter eingekoppelte elektromagnetische Strahlung zumindest teilweise transparent ist. Als Vollkörper ausgebildet kann auch bedeuten, dass der durch die Lichteintrittsfläche, die Seitenflächen und die Lichtaustrittsfläche begrenzte Lichtleiter mit einem Material befüllt ist. Das Füllmaterial kann sich dabei vom Material der Seitenflächen und / oder dem Material, aus dem Lichteintritts- und Lichtaustrittsfläche gebildet sind, unterscheiden.

Reflexion von Strahlung an den Seitenflächen des Lichtleiters findet dann bevorzugt aufgrund von Totalreflexion statt. Bevorzugt weist das Material einen Brechungsindex größer 1,3 auf, besonders bevorzugt einen Brechungsindex zwischen 1,4 und 1,7.
Gemäß zumindest einer Ausführungsform ist das Material durch einen Kunststoff gegeben. Bevorzugt umfasst das Material einen der folgenden Kunststoffe: PMMA (Polymethylmethacrylate), Polycarbonat, PMMI (Poly-N-Methyl Methacrylimide), COC (Cycloolefin Copolymer). Gemäß Anspruch 1 weist das optoelektronische Bauteil eine Strahlungsquelle und einen Lichtleiter auf. Bei der Strahlungsquelle handelt es sich um ein Bauelement, das zur Erzeugung elektromagnetischer Strahlung geeignet ist. Beispielsweise handelt es sich bei der Strahlungsquelle um einen oder mehrere Leuchtdiodenchips oder um eine oder mehrere Leuchtdioden.
Bei dem Lichtleiterhandelt es sich um ein optisches Bauelement, das geeignet ist, elektromagnetische Strahlung von einer Lichteintrittsfläche zu einer Lichtaustrittsfläche zu führen. Bevorzugt erfolgt die Führung der elektromagnetischen Strahlung dabei aufgrund von Reflexionen - beispielsweise Totalreflexionen - an Seitenflächen des Lichtleiters. Die Seitenflächen verbinden die Lichteintrittsfläche mit der Lichtaustrittsfläche. Insbesondere ist unter Lichtleiter also keine Linse zu verstehen. Beispielsweise kann es sich bei dem Lichtleiter um einen Lichtleiter wie er in zumindest einem der oben aufgeführten Ausführungsformen beschrieben ist handeln.

Gemäß der Erfindung wird von der Strahlungsquelle emittierte elektromagnetische Strahlung beim Durchtritt durch die Lichteintrittsfläche gebrochen. Das heißt, es findet an der Lichteintrittsfläche eine Brechung der Strahlung statt, die in den Lichtleiter eintritt. Bevorzugt wird ein Großteil der in den Lichtleiter eingekoppelten Strahlung an der Lichteintrittsfläche gebrochen. Durch die Brechung der Strahlung an der Lichteintrittsfläche kann erreicht sein, dass in den Lichtleiter eintretende elektromagnetische Strahlung in solchen Winkeln auf die Seitenflächen des Lichtleiters gelenkt wird, dass sie die Bedingung für Totalreflexion erfüllt. Die Strahlung kann auf diese Weise im Lichtleiter gehalten werden und wird nicht durch die Seitenfläche transmittiert. Ein Spalt befindet sich zwischen der Lichteintrittsfläche des Lichtleiters und der Strahlungsaustrittsfläche der Strahlungsquelle. Der Spalt kann beispielsweise mit Luft gefüllt sein. Gemäß der Erfindung umschließt die Lichteintrittsfläche die Strahlungsquelle vollständig. Das heißt der konkave Bereich des Lichtleiters, der durch die Lichteintrittsfläche begrenzt ist, ist nach Art einer Abdeckung über die Strahlungsquelle gestülpt. Die Strahlungsquelle ist also in diesem Fall von der Lichteintrittsfläche umschlossen. Auf diese Weise kann sämtliche von der Strahlungsquelle emittierte Strahlung auf die Lichteintrittsfläche des Lichtleiters treffen. Gemäß zumindest einer Ausführungsform des optoelektronischen Bauteils ist die Strahlungsquelle durch eines der folgenden optoelektronischen Bauelemente gegeben: Leuchtdiode, - Leuchtdiodenchip, VCSEL (Vertical Cavity Surface Emitting Laser).
Im Folgenden wird der hier beschriebene Lichtleiter sowie das hier beschriebene optoelektronische Bauteil anhand von Ausführungsbeispielen und den dazu gehörigen Figuren näher erläutert.
In den Ausführungsbeispielen und Figuren sind gleiche oder gleichwirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.
Figur 1A zeigt eine schematische Schnittdarstellung eines nicht erfindungsgemäßen Beispiels des beschriebenen Bauteils.
Figur 1B zeigt eine schematische perspektivische Darstellung des nicht erfindungsgemäßen Beispiels des hier beschriebenen Lichtleiters.
Figur 2A zeigt eine schematische Schnittdarstellung eines nicht erfindungsgemäßen Beispiels des hier beschriebenen Lichtleiters.
Figur 2B zeigt eine schematische perspektivische Darstellung des Beispiels des hier beschriebenen Lichtleiters.
Figur 3 zeigt eine schematische Schnittdarstellung eines Ausführungsbeispiels des hier beschriebenen Lichtleiters.
Figur 4 zeigt eine schematische Schnittdarstellung eines Ausführungsbeispiels des hier beschriebenen optoelektronischen Bauteils.

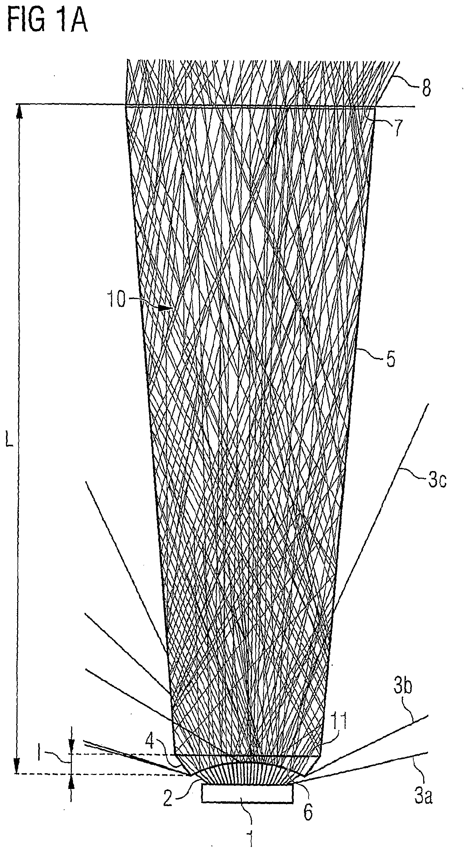

Figur 1A zeigt eine schematische Schnittdarstellung eines nicht erfindungsgemäßen Beispiels des hier beschriebenen optoelektronischen Bauteils.
Das Bauteil weist eine Strahlungsquelle 1 auf. Bei der Strahlungsquelle 1 handelt es sich beispielsweise um eine oder mehrere Leuchtdioden oder um einen oder mehrere Leuchtdiodenchips. Bevorzugt weißt die Strahlungsquelle 1 vier Leuchtdiodenchips auf, die in zwei Reihen zu je zwei Chips angeordnet sind.
Bevorzugt weist ein Leuchtdiodenchip der Strahlungsquelle 1 eine Lichtauskoppelfläche auf, durch die ein Großteil der vom Leuchtdiodenchip emittierten elektromagnetischen Strahlung ausgekoppelt wird. Die Lichtauskoppelfläche ist beispielsweise durch einen Teil der Oberfläche des Leuchtdiodenchips gegeben. Bevorzugt ist die Lichtauskoppelfläche durch eine Hauptfläche des Leuchtdiodenchips gegeben, die beispielsweise parallel zu einer Epitaxie-Schichtfolge des Leuchtdiodenchips angeordnet ist, welche geeignet ist, elektromagnetische Strahlung zu erzeugen.

Dazu kann die Epitaxie-Schichtfolge beispielsweise einen pn-Übergang, eine Doppelheterostruktur, eine Einfachquantentopf- oder besonders bevorzugt eine Mehrfachquantentopfstruktur aufweisen. Die Bezeichnung Quantentopfstruktur umfasst im Rahmen der Anmeldung jegliche Struktur, bei der Ladungsträger durch Einschluss ("Confinement") eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Bevorzugt handelt es sich bei dem Leuchtdiodenchip um einen Halbleiterleuchtdiodenchip, bei dem das Aufwachssubstrat zumindest teilweise entfernt ist und auf dessen dem ursprünglichen Aufwachssubstrat abgewandter Oberfläche ein Trägerelement aufgebracht ist.

Das Trägerelement kann verglichen mit einem Aufwachssubstrat relativ frei gewählt werden. Bevorzugt wird ein Trägerelement gewählt, das hinsichtlich seines Temperaturausdehnungskoeffizienten besonders gut an die strahlungserzeugende Epitaxie-Schichtfolge angepasst ist. Weiter kann das Trägerelement ein Material enthalten, das besonders gut wärmeleitend ist. Auf diese Weise wird die im Betrieb vom Leuchtdiodenchip erzeugte Wärme besonders effizient an das Wärmeleitelement abgeführt.

Solche durch das Entfernen des Aufwachssubstrats hergestellten Leuchtdiodenchips werden oftmals als Dünnfilmleuchtdiodenchips bezeichnet und zeichnen sich bevorzugt durch die folgenden Merkmale aus:
- An einer zum Trägerelement hingewandten ersten Hauptfläche der strahlungserzeugenden Epitaxie-Schichtfolge ist eine reflektierende Schicht oder Schichtenfolge aufgebracht oder ausgebildet, die zumindest einen Teil in der Epitaxie-Schichtfolge erzeugten elektromagnetischen Strahlung in diese zurückreflektiert.
- Die Epitaxie-Schichtfolge weist bevorzugt eine Dicke von maximal zwanzig Mikrometer, besonders bevorzugt von maximal zehn Mikrometer auf.
- Weiter enthält die Epitaxie-Schichtfolge bevorzugt mindestens eine Halbleiterschicht mit zumindest einer Fläche, die eine Durchmischungsstruktur aufweist. Im Idealfall führt diese Durchmischungsstruktur zu einer annähernd ergodischen Verteilung des Lichts in der Epitaxie-Schichtfolge, das heißt sie weist ein möglichst ergodisch, stochastisches Streuverhalten auf.

Ein Grundprinzip eines Dünnfilmleuchtdiodenchips ist beispielsweise in der Druckschrift Schnitzer I. et al., "30% external quantum efficiency from surface textured LEDs", Applied Physics Letters, Okt 1993, Bd. 63, Seiten 2174 - 2176 beschrieben, deren Offenbarungsgehalt, das Grundprinzip eines Dünnfilmleuchtdiodenchips betreffend, hiermit durch Rückbezug aufgenommen wird.

Ein Großteil der von der Strahlungsquelle 1 emittierten elektromagnetischen Strahlung 2 tritt durch die vorzugsweise einzige Lichteintrittsfläche 6 in den Lichtleiter 10 ein. Dabei ist es möglich, dass ein kleiner Teil besonders divergenter Strahlung 3a im Spalt 12 zwischen Strahlungsquelle 1 und Lichtleiter 10 seitlich entweicht. Der Spalt 12 kann beispielsweise mit Luft gefüllt sein.

Der Lichtleiter 10 ist als Vollkörper ausgeführt. Dazu umfasst der Lichtleiter ein dielektrisches Material, bevorzugt einen Kunststoff wie PMMA, Polycarbonat, COC, PMMI. Der Lichtleiter ist transparent für die von der Strahlungsquelle 1 emittierte elektromagnetische Strahlung 2.
Bevorzugt handelt es sich bei der Strahlung 2 um Licht im sichtbaren Frequenzbereich. Der Brechungsindex des dielektrischen Materials beträgt bevorzugt wenigstens 1,3, besonders bevorzugt zwischen 1,4 und 1,7.

Die Lichteintrittsfläche 6 ist im gezeigten Beispiel als konkav gewölbte Fläche ausgebildet. Beispielsweise weisen zumindest Teile der Lichteintrittsfläche 6 eine konkave sphärische, elliptische oder asphärische Krümmung auf. Das heißt zumindest Teile der Lichteintrittsfläche 6 sind in dieser Weise gekrümmt. Die Lichteintrittsfläche 6 kann auch bikonisch, bikonisch sphärisch oder bikonisch asphärisch geformt sein. Die Krümmung der Lichteintrittsfläche ist so gewählt, dass durch die Lichteintrittsfläche 6 eintretende Strahlung 2 zum großen Teil derart gebrochen wird, dass die gebrochene Strahlung in Winkeln auf die Seitenflächen 4, 5 des Lichtleiters auftrifft, bei denen die Bedingung für Totalreflexion an den Seitenflächen 4, 5 erfüllt ist.
Der Lichtleiter 10 unterteilt sich in zwei Abschnitte. Der erste Abschnitt wird durch die Seitenflächen 4 des Lichtleiters begrenzt. Der zweite Abschnitt ist durch die Seitenflächen 5 des Lichtleiters begrenzt.

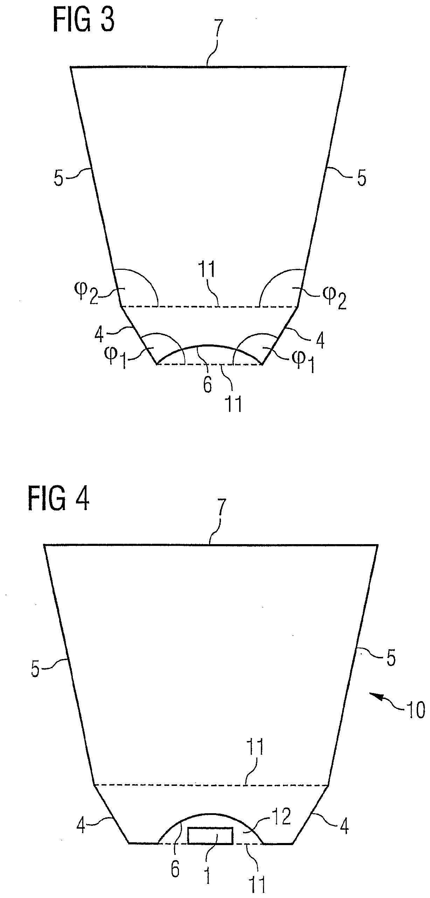

Wie beispielsweise Figur 3 verdeutlicht, schließen die Seitenflächen 4 einen ersten Winkel ϕ₁ mit der Querschnittsfläche 11 des Lichtleiters 10 ein. Die Seitenflächen 5 im zweiten. Abschnitt des Lichtleiters schließen einen zweiten Winkel ϕ₂ mit der Querschnittsfläche 11 des Lichtleiters ein. Sowohl die Seitenflächen 4 des ersten Abschnitts als auch die Seitenflächen 5 des zweiten Abschnitts sind im gezeigten Ausführungsbeispiel eben ausgebildet. Die ersten Winkel ϕ₁ sind größer als die zweiten Winkel ϕ₂. Das heißt, die Querschnittsfläche 11 des Lichtleiters 10 nimmt im ersten Abschnitt, welcher der Lichteintrittsfläche 6 direkt nachgeordnet ist, stärker mit dem Abstand von der Lichteintrittsfläche 6 zu als im zweiten Abschnitt des Lichtleiters 10.
Die ersten Winkel ϕ₁ betragen bevorzugt zwischen 125 und 140 Grad.
Im zweiten Abschnitt, in dem der Lichtleiter 10 durch die Seitenflächen 5 begrenzt ist, nimmt die Querschnittsfläche 11 des Lichtleiters 10 weniger stark zu. Die zweiten Winkel ϕ₂ betragen bevorzugt zwischen 95 Grad und 135 Grad.
Durch die stärkere Zunahme der Querschnittsfläche 11 im ersten Abschnitt des Lichtleiters ist gewährleistet, dass auch noch divergente Strahlung, die durch die Lichteintrittsfläche 6 in den Lichtleiter 10 eingekoppelt wird, die Bedingung für Totalreflexion an den Seitenwänden 4 erfüllt. Divergente Strahlung bezeichnet dabei Strahlung, die einen Winkel mit der Querschnittsfläche 11 des Lichtleiters einschließt, der stark von einem 90 Grad Winkel abweicht. Nur ein geringer Anteil 3b der in den Lichtleiter 10 eingekoppelten Strahlung 2 erfüllt die Bedingung für Totalreflexion an den Seitenflächen 4 nicht und tritt aus dem Lichtleiter 10 aus.

Die in den Lichtleiter 10 eingekoppelte elektromagnetische Strahlung 2 wird an den Seitenflächen 4, 5 des Lichtleiters 10 zum Teil mehrfach reflektiert, bevor sie den Lichtleiter durch die Lichtaustrittsfläche 7 verlässt.

Nur ein geringer Anteil 3c der in den Lichtleiter 10 eingekoppelten elektromagnetischen Strahlung ist derart divergent, dass die Bedingung für Totalreflexion an den Seitenflächen 5 des zweiten Abschnitts nicht erfüllt werden kann und daher vor Erreichen der Lichtaustrittsfläche 7 aus dem Lichtleiter 10 austritt.

Der erste Abschnitt des Lichtleiters 10, der durch die Seitenflächen 4 begrenzt ist, weist eine Länge l auf, die bevorzugt maximal zwanzig Prozent der Gesamtlänge L, besonders bevorzugt maximal zehn Prozent der Gesamtlänge L des Lichtleiters 10 beträgt.

Der überwiegende Teil der in den Lichtleiter 10 eingekoppelten Strahlung 2 tritt durch die Lichtaustrittsfläche 7 aus diesem aus. Im gezeigten Ausführungsbeispiel ist die Lichtaustrittsfläche 7 eben ausgebildet. Es ist aber auch möglich, dass die Lichtaustrittsfläche beispielsweise eine sphärische, elliptische oder asphärische Krümmung aufweist. Bevorzugt ist die Krümmung der Lichtaustrittsfläche dabei konvex. Die Krümmung der Lichtaustrittsfläche 7 kann zum Beispiel die Divergenz der durch die Lichtaustrittsfläche 7 tretenden Strahlung 8 weiter verringern.

Bevorzugt ist der Lichtleiter einteilig ausgebildet. Das heißt erster und zweiter Abschnitt des Lichtleiters 10 sind integral gefertigt.

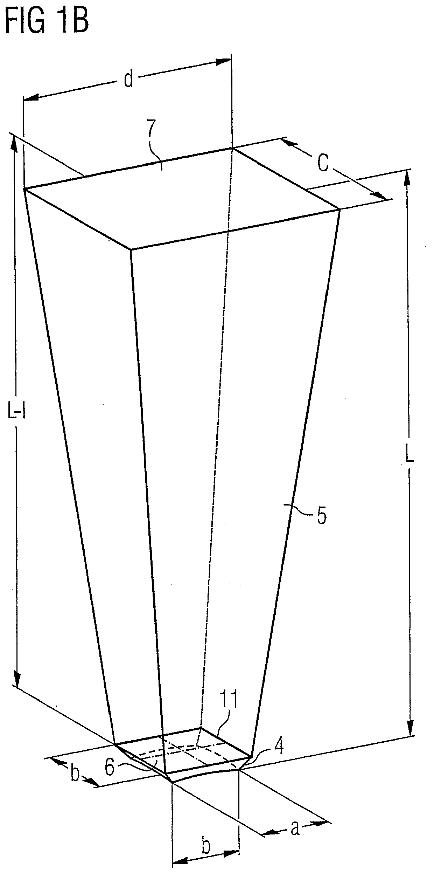

Die Figur 1B zeigt eine schematische perspektivische Darstellung des Lichtleiters 10. Bevorzugt beträgt die Gesamtlänge L des Lichtleiters 10 zwischen 5 und 50mm, besonders bevorzugt zwischen 15 und 30mm. Die Länge des ersten Abschnitts l des Lichtleiters 10 beträgt bevorzugt zwischen 2 und 30 Prozent der Gesamtlänge L, besonders bevorzugt zwischen 10 und 20 Prozent der Gesamtlänge L. Im Beispiel der Figur 1B beträgt L 20mm, l beträgt 5mm.
Die Lichteintrittsfläche 6 ist in einer quadratischen Fläche angeordnet mit einer Kantenlänge a von 2,4mm. Die Querschnittsfläche 11 am Übergang vom ersten zum zweiten Abschnitt des Lichtleiters beträgt 3,2mm mal 3,2mm. Das heißt, die Kantenlänge b beträgt dort 3,2mm. Die Lichtaustrittsfläche 7 ist in diesem Beispiel rechteckig. Die ersten Kantenlänge c beträgt 6,8mm. Die zweite Kantenlänge d beträgt 7,8mm.

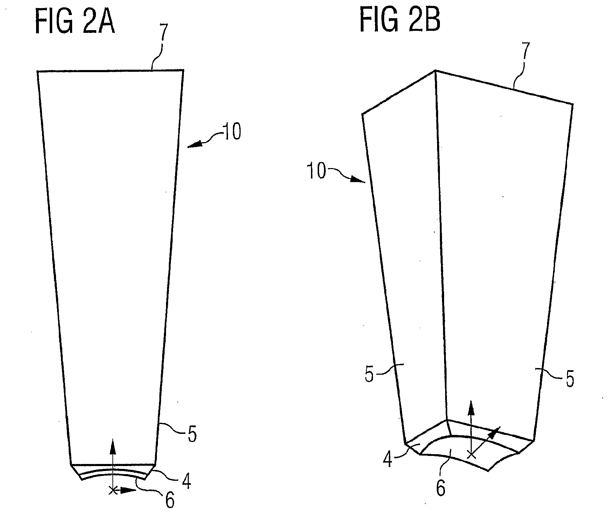

Die Figuren 2A und 2B zeigen eine schematisch Schnittdarstellung und die dazugehörige perspektivische Prinzipskizze eines hier beschriebenen Lichtleiters. Wie den Figuren zu entnehmen ist, sind die beiden Abschnitte des Lichtleiters 10, die durch die Seitenflächen 4 beziehungsweise 5 begrenzt sind, jeweils als Pyramidenstümpfe mit rechteckiger bzw. quadratischer Grundfläche ausgeführt. Beide Abschnitte bilden jeweils einen optischen Konzentrator, der in umgekehrter Richtung durchstrahlt wird. Die Seitenflächen 4 des ersten Abschnitts sind zur Totalreflexion besonders divergenter Strahlung geeignet. Von den Seitenflächen 4 wird die besonders divergente Strahlung in den zweiten Abschnitt, der durch die Seitenflächen 5 begrenzt ist, reflektiert.

Figur 4 zeigt eine schematische Schnittdarstellung eines Ausführungsbeispiels des hier beschriebenen optoelektronischen Bauelements. Dabei überspannt die Lichteintrittsfläche 6 die Strahlungsquelle 1 vollständig. Die Lichteintrittsfläche 6 ist als Ausnehmung in der der Lichtaustrittsfläche 7 abgewandten Oberfläche des Lichtleiters 10 ausgeführt. Zwischen Strahlungsquelle 1 und Lichteintrittsfläche 6 befindet sich ein Spalt 12, der beispielsweise mit Luft gefüllt sein kann. Es ist aber auch möglich, dass der Spalt 12 mit einem transparenten Vergussmaterial gefüllt ist, dessen Brechungsindex kleiner ist als der des Materials aus dem der Lichtleiter 10 gebildet ist. Im Ausführungsbeispiel der Figur 4 stellt der Lichtleiter 10 neben seinen optischen Eigenschaften einen mechanischen Schutz der Strahlungsquelle 11 dar.

Die Erfindung ist nicht durch die Beschreibung anhand des Ausführungsbeispiels beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.
Diese Patentanmeldung beansprucht die Prioritäten der deutschen Patentanmeldungen 102005009028.1 und 102005018336.0-51, deren Offenbarungsgehalt hiermit durch Rückbezug aufgenommen wird.

## Patentansprüche

1. Optoelektronisches Bauteil, aufweisend
- eine Strahlungsquelle (1), und
- einen als Vollkörper ausgebildeten Lichtleiter (10) aufweisend
- eine unebene Lichteintrittsfläche (6) und
- ebene Seitenflächen (4), die der Lichteintrittsfläche (6) direkt nachgeordnet sind, wobei
- die Querschnittsfläche (11) des Lichtleiters (10) mit dem Abstand von der Lichteintrittsfläche (6) zunimmt,
- die Querschnittsfläche (11) des Lichtleiters (10) in einem ersten Abschnitt stärker zunimmt als in einem zweiten Abschnitt des Lichtleiters (10),
- der erste Abschnitt des Lichtleiters (10) der Lichteintrittsfläche (6) direkt nachgeordnet ist,
- der Lichtleiter im ersten und im zweiten Abschnitt jeweils die Form eines Pyramidenstumpfes aufweist oder der Lichtleiter im ersten und im zweiten Abschnitt jeweils die Form eines Kegelstumpfes aufweist,
- sich zwischen der Strahlungsquelle (1) und der Lichteintrittsfläche (6) ein Spalt (12) befindet, der mit Luft oder mit einem transparenten Vergussmaterial gefüllt ist, dessen Brechungsindex kleiner ist als der des Materials aus dem der Lichtleiter (10) gebildet ist,
- ein Großteil der von der Strahlungsquelle (1) emittierten elektromagnetischen Strahlung (2) beim Eintritt in den Lichtleiter (10) gebrochen wird,
- die Strahlungsquelle (1) durch eines der folgenden optoelektronischen Bauelemente gegeben ist: Leuchtdiode, Leuchtdiodenchip, Vertical Cavity Surface Emitting Laser (VCSEL), **dadurch gekennzeichnet, dass**
- die Lichteintrittsfläche (6) die Strahlungsquelle (1) vollständig umschließt, und
- die Länge (l) des ersten Abschnitts des Lichtleiters (10) maximal 20 % der Gesamtlänge (L) des Lichtleiters (10) beträgt

2. Optoelektronisches Bauteil nach Anspruch 1,
bei dem der Lichtleiter (10)mehr als zwei Abschnitte aufweist.

3. Optoelektronisches Bauteil nach einem der vorherigen Ansprüche,
bei dem die Seitenflächen (4) des Lichtleiters (10) im ersten Abschnitt erste Winkel (ϕ₁) mit der Querschnittsfläche (11) des Lichtleiters (10) einschließen, die zwischen 125° und 140° betragen.

4. Optoelektronisches Bauteil nach einem der vorherigen Ansprüche
bei dem die Seitenflächen (5) des zweiten Abschnitts des Lichtleiters (10) zweite Winkel (ϕ₂) mit der Querschnittsfläche des Lichtleiters einschließen, die zwischen 95° und 135° betragen.

5. Optoelektronisches Bauteil nach Anspruch 1, bei dem die Länge (l) des ersten Abschnitts des Lichtleiters (10) maximal 10 % der Gesamtlänge (L) des Lichtleiters (10) beträgt.

6. Optoelektronisches Bauteil nach einem der vorherigen Ansprüche,
bei dem die Lichteintrittsfläche (6) des Lichtleiters (10) konkav ausgebildet ist.

7. Optoelektronisches Bauteil nach einem der vorherigen Ansprüche,
bei dem die Lichteintrittsfläche (6) des Lichtleiters (10) eine der folgenden Krümmungen aufweist: Sphärisch, elliptisch, asphärisch, bikonisch, bikonisch asphärisch, bikonisch sphärisch.

8. Optoelektronisches Bauteil nach einem der vorherigen Ansprüche,
aufweisend eine Lichtaustrittsfläche (7) des Lichtleiters (10), durch die ein Großteil der durch die Lichteintrittsfläche (6) in den Lichtleiter (10) eingekoppelten elektromagnetischen Strahlung (2,8) den Lichtleiter (10) verlässt.

9. Optoelektronisches Bauteil nach Anspruch 8, bei dem die Lichtaustrittsfläche (7) des Lichtleiters (10) eine Krümmung aufweist.

10. Optoelektronisches Bauteil nach einem der Ansprüche 8 oder 9, bei dem die Lichtaustrittsfläche (7) des Lichtleiters (10) eine konvexe Krümmung aufweist.

11. Optoelektronisches Bauteil nach einem der Ansprüche 8 bis 10, bei dem die Lichtaustrittsfläche (7) des Lichtleiters (10) eine der folgenden Krümmungen aufweist: Sphärisch, elliptisch, asphärisch, bikonisch, bikonisch asphärisch, bikonisch sphärisch.

12. Optoelektronisches Bauteil nach Anspruch 8, bei dem die Lichtaustrittsfläche (7) des Lichtleiters (10) durch eine Freiformfläche gebildet ist.

13. Optoelektronisches Bauteil nach Anspruch 8, bei dem die Lichtaustrittsfläche (7) des Lichtleiters (10) eben ist.

14. Optoelektronisches Bauteil nach Anspruch 1, bei dem das Material des Lichtleiters (10) einen Brechungsindex größer 1,3 aufweist.

15. Optoelektronisches Bauteil nach Anspruch 14, bei dem das Material zumindest eines der folgenden Materialien umfasst: PMMA, Polycarbonat, PMMI, COC.

16. Optoelektronisches Bauteil nach einem der vorherigen Ansprüche, bei dem die Divergenz eines Strahlenbündels beim Durchtritt durch den Lichtleiter (10) verringert wird.

## Claims

1. Optoelectronic component, comprising
- a radiation source (1), and
- a light guide (10) formed as a solid body, comprising
- an uneven light entrance surface (6) and
- plane side surfaces (4), which are arranged directly downstream of the light entrance surface (6), wherein
- the cross-sectional area (11) of the light guide (10) increases with the distance from the light entrance surface (6),
- the cross-sectional area (11) of the light guide (10) increases more strongly in a first section than in a second section of the light guide (10),
- the first section of the light guide (10) is arranged directly downstream of the light entrance surface (6),
- the light guide has in each case the shape of a truncated pyramid in the first and in the second section, or the light guide has in each case the shape of a truncated cone in the first and in the second section,
- a gap (12) is formed between the radiation source (1) and the light entrance surface (6), which is filled with air or with a transparent casting material, the refractive index of which is smaller than that of the material from which the light guide (10) is formed,
- a large part of the electromagnetic radiation (2) emitted by the radiation source (1) is refracted when entering the light guide (10),
- the radiation source (1) is given by one of the following optoelectronic components: light-emitting diode, light-emitting diode chip, vertical cavity surface emitting laser (VCSEL), **characterized in that**
- the light entrance surface (6) completely encloses the radiation source (1), and
- the length (1) of the first section of the light guide (10) is at most 20% of the total length (L) of the light guide (10) .

2. Optoelectronic component according to claim 1,
in which the light guide (10) has more than two sections.

3. Optoelectronic component according to one of the preceding claims,
in which the side surfaces (4) of the light guide (10) of the first section encloses first angles (ϕ₁) with the cross-sectional area (11) of the light guide (10}, being between 125° and 140° inclusive.

4. Optoelectronic component according to one of the preceding claims,
in which the side surfaces (5) of the light guide (10) of the second section encloses second angles (ϕ₂) with the cross-sectional area (11) of the light guide, being between 95° and 135° inclusive.

5. Optoelectronic component according to claim 1,
in which the length (1) of the first section of the light guide (10) is at most 10% of the total length (L) of the light guide (10).

6. Optoelectronic component according to one of the preceding claims,
in which the light entrance surface (6) of the light guide (10) is concave.

7. Optoelectronic component according to one of the preceding claims,
in which the light entrance surface (6) of the light guide (10) comprises one of the following curvatures: spherical, elliptical, aspherical, bi-conical, bi-conical aspherical, bi-conical spherical.

8. Optoelectronic component according to one of the preceding claims,
comprising a light exit surface (7) of the light guide (10) through which a large part of the electromagnetic radiation (2, 8), which is coupled into the light guide (10) by the light entry surface (6), leaves the light guide (10).

9. Optoelectronic component according to claim 8,
in which the light exit surface (7) of the light guide (10) has a curvature.

10. Optoelectronic component according to claims 8 or 9,
in which the light exit surface (7) of the light guide (10) has a convex curvature.

11. Optoelectronic component according to one of the claims 8 to 10,
in which the light exit surface (7) of the light guide (10) comprises one of the following curvatures: spherical, elliptical, aspherical, bi-conical, bi-conical aspherical, bi-conical spherical.

12. Optoelectronic component according to claim 8,
in which the light exit surface (7) of the light guide (10) is formed by a free-form surface.

13. Optoelectronic component according to claim 8,
in which the light exit surface (7) of the light guide (10) is flat.

14. Optoelectronic component according to claim 1,
in which the material of the light guide (10) has a refractive index greater than 1.3.

15. Optoelectronic component according to claim 14,
in which the material comprises at least one of the following materials: PMMA, polycarbonate, PMMI, COC.

16. Optoelectronic component according to one of the preceding claims,
in which the divergence of a radiation beam is reduced as it passes through the light guide (10).

## Revendications

1. Pièce optoélectronique, présentant
- une source de rayonnement (1), et
- un conducteur de lumière (10) conçu comme corps plein, présentant
- une surface irrégulière d'entrée de la lumière (6) et
- des surfaces latérales (4) planes situées directement après la surface d'entrée de la lumière (6), dans lequel
- la surface de section (11) du conducteur de lumière (10) augmentant avec la distance par rapport à la surface d'entrée de lumière (6) augmente,
- la surface de section (11) du conducteur de lumière (10) augmentant plus fort dans un premier tronçon que dans un deuxième tronçon du conducteur de lumière (10),
- le premier tronçon du conducteur de lumière (10) étant situé directement après la surface d'entrée de la lumière (6),
- le conducteur de lumière présentant respectivement dans le premier et dans le deuxième tronçon la forme d'un tronc de pyramide ou le conducteur de lumière présentant respectivement dans le premier et dans le deuxième tronçon la forme d'un cône tronqué,
- une fente (12) se trouvant entre la source de rayonnement (1) et la surface d'entrée de la lumière (6), laquelle fente est remplie d'air ou d'un matériau coulé transparent dont l'indice de réfraction est plus petit que celui du matériau dont est constitué le conducteur de lumière (10),
- une grande partie du rayonnement (2) électromagnétique émis par la source de rayonnement (1) est réfractée en entrant dans le conducteur de lumière (10),
- la source de rayonnement (1) est fournie par une des pièces optoélectroniques suivantes : diode électroluminescente, puce pour diode électroluminescente, laser à cavité verticale émettant par la surface (VCSEL), **caractérisée en ce que**
- la surface d'entrée de la lumière (6) encercle complètement la source de rayonnement (1), et
- la longueur (l) du premier tronçon du conducteur de lumière (10) est de 20 % au maximum de la longueur totale (L) du conducteur de lumière (10).

2. Pièce optoélectronique selon la revendication 1, dans laquelle le conducteur de lumière (10) présente plus de deux tronçons.

3. Pièce optoélectronique selon l'une quelconque des revendications précédentes,
dans laquelle les surfaces latérales (4) du conducteur de lumière (10) contiennent dans le premier tronçon des premiers angles (φ₁) avec la surface de section (11) du conducteur de lumière (10), lesdits angles étant d'entre 125 et 140 degrés.

4. Pièce optoélectronique selon l'une quelconque des revendications précédentes,
dans laquelle les surfaces latérales (5) du deuxième tronçon du conducteur de lumière (10) contiennent des deuxièmes angles (φ₂) avec la surface de section du conducteur de lumière (10), lesdits angles étant d'entre 95 et 135 degrés.

5. Pièce optoélectronique selon la revendication 1, dans laquelle la longueur (l) du premier tronçon du conducteur de lumière (10) est de 10 % au maximum de la longueur totale (L) du conducteur de lumière (10).

6. Pièce optoélectronique selon l'une quelconque des revendications précédentes, dans laquelle la surface d'entrée de la lumière (6) du conducteur de lumière (10) est conçue de forme concave.

7. Pièce optoélectronique selon l'une quelconque des revendications précédentes, dans laquelle la surface d'entrée de la lumière (6) du conducteur de lumière (10) présente une des courbures suivantes : sphérique, elliptique, asphérique, biconique, biconique asphérique, biconique sphérique.

8. Pièce optoélectronique selon l'une quelconque des revendications précédentes, présentant une surface de sortie de la lumière (7) du conducteur de lumière (10), à travers laquelle une grande partie du rayonnement électromagnétique (2, 8) couplé dans le conducteur de lumière (10) quitte ledit conducteur de lumière (10).

9. Pièce optoélectronique selon la revendication 8, dans laquelle la surface de sortie de la lumière (7) du conducteur de lumière (10) présente une courbure.

10. Pièce optoélectronique selon l'une quelconque des revendications 8 ou 9, dans laquelle la surface de sortie de la lumière (7) du conducteur de lumière (10) présente une courbure convexe.

11. Pièce optoélectronique selon l'une quelconque des revendications 8 à 10, dans laquelle la surface de sortie de la lumière (7) du conducteur de lumière (10) présente une des courbures suivantes : sphérique, elliptique, asphérique, biconique, biconique asphérique, biconique sphérique.

12. Pièce optoélectronique selon la revendication 8, dans laquelle la surface de sortie de la lumière (7) du conducteur de lumière (10) est formée par une surface de forme libre.

13. Pièce optoélectronique selon la revendication 8, dans laquelle la surface de sortie de la lumière (7) du conducteur de lumière (10) est plane.

14. Pièce optoélectronique selon la revendication 1, dans laquelle le matériau du conducteur de lumière (10) présente un indice de réfraction supérieur à 1,3.

15. Pièce optoélectronique selon la revendication 14, dans laquelle le matériau comprend au moins un des matériaux suivants : PMMA, polycarbonate, PMMI, COC.

16. Pièce optoélectronique selon l'une quelconque des revendications précédentes, dans laquelle la divergence d'un faisceau lumineux est réduite en traversant le conducteur de lumière (10).
